(19) Europäisches Patentamt
European Patent Office
Office européen des brevets

(11) **EP 2 988 181 B1**

(12) **EUROPÄISCHE PATENTSCHRIFT**

(45) Veröffentlichungstag und Bekanntmachung des Hinweises auf die Patenterteilung:
**03.07.2019   Patentblatt 2019/27**

(51) Int Cl.:
***G05B 15/02*** *(2006.01)*      ***H03H 17/06*** *(2006.01)*
***G05B 5/01*** *(2006.01)*

(21) Anmeldenummer: **14181404.6**

(22) Anmeldetag: **19.08.2014**

(54) **Regeleinrichtung mit lernfähiger Fehlerkompensation**

Control device with trainable error compensation

Dispositif de réglage à compensation d'erreur adaptative

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**24.02.2016   Patentblatt 2016/08**

(73) Patentinhaber: **Siemens Aktiengesellschaft 80333 München (DE)**

(72) Erfinder:
• **Geissdörfer, Klaus**
  **91056 Erlangen (DE)**
• **Hamm, Carsten**
  **91058 Erlangen (DE)**
• **Haschka, Markus Stephan**
  **90419 Nürnberg (DE)**
• **Schäfers, Elmar**
  **90763 Fürth (DE)**

(56) Entgegenhaltungen:
**EP-A1- 1 580 406      EP-A1- 2 116 912**

## Beschreibung

Die vorliegende Erfindung geht aus von einer Regeleinrichtung zum Regeln einer Regelstrecke,

- wobei die Regeleinrichtung einen vorderen Knotenpunkt, einen hinteren Knotenpunkt, einen Regler und einen Kompensationskreis aufweist,
- wobei dem vorderen Knotenpunkt ein ausgangsseitig der Regelstrecke mittels einer Messeinrichtung erfasster Istwert und ein korrespondierender Sollwert zugeführt werden und der vordere Knotenpunkt durch Differenzbildung von Sollwert und Istwert eine Regeldifferenz ermittelt,
- wobei dem hinteren Knotenpunkt die Regeldifferenz zugeführt wird und der hintere Knotenpunkt die Regeldifferenz dem Regler zuführt,
- wobei der Regler anhand des ihm zugeführten Signals ein Stellsignal für die Regelstrecke ermittelt und an die Regelstrecke ausgibt.

Die vorliegende Erfindung geht weiterhin aus von einer softwareprogrammierbaren Regeleinrichtung mit einem Softwaremodul, das Maschinencode umfasst, dessen Abarbeitung durch eine softwareprogrammierbare Regeleinrichtung bewirkt, dass die Regeleinrichtung entsprechend ausgebildet ist.

Derartige Regeleinrichtungen und die zugehörigen Softwaremodule sind allgemein bekannt.

Bei manchen geregelten technischen Größen - insbesondere Lagewerten bei Rundachsen - treten oftmals periodische Störungen auf. Derartige Störungen können beispielsweise durch Trägheits- oder Bearbeitungskräfte bei Werkzeugmaschinen oder anderen Produktionsmaschinen auftreten. Eine Unterdrückung derartiger Störungen verbessert die Qualität der Regelung erheblich, manchmal um mehr als eine Größenordnung.

Zur Unterdrückung derartiger periodischer Störungen sind lernfähige Regelungen bekannt. Der einschlägige Fachbegriff für derartige lernfähige Regelungen ist Repetitive Control. Die genaue Implementierung derartiger lernfähiger Regelungen wird jedoch in der Regel von den Herstellern derartiger Regelungen nicht publik gemacht. EP2116912 beschreibt ein System zur Unterdrückung von periodischen Störungen.

Die Aufgabe der vorliegenden Erfindung besteht darin, bei einer Regeleinrichtung der eingangs genannten Art, bei welcher der erfasste Istwert mit einer eine Periodendauer aufweisenden Störung beaufschlagt ist, eine einfache und zuverlässig arbeitende Regeleinrichtung anzugeben, mittels derer der periodische Fehler hochgenau kompensiert wird.

Die Aufgabe wird durch eine Regeleinrichtung mit den Merkmalen des Anspruchs 1 gelöst. Vorteilhafte Ausgestaltungen der Regeleinrichtung sind Gegenstand der abhängigen Ansprüche 2 bis 13.

Erfindungsgemäß wird eine Regeleinrichtung der eingangs genannten Art dadurch ausgestaltet,

- dass dem hinteren Knotenpunkt zusätzlich zur Regeldifferenz ein Kompensationssignal zugeführt wird und der hintere Knotenpunkt dem Regler ein durch Addieren von Regeldifferenz und Kompensationssignal gebildetes äußeres Summensignal zuführt,
- dass der Regler das Stellsignal anhand des ihm zugeführten äußeren Summensignals ermittelt,
- dass zwischen dem vorderen und dem hinteren Knotenpunkt ein äußerer Abgreifpunkt angeordnet ist, an dem die Regeldifferenz abgegriffen und dem Kompensationskreis zugeführt wird,
- dass der Kompensationskreis das Kompensationssignal ermittelt und dem hinteren Knotenpunkt zuführt,
- dass der Kompensationskreis einen inneren Knotenpunkt, ein Frequenzfilter, einen vorderen Pufferspeicher und einen hinteren Pufferspeicher aufweist,
- dass dem inneren Knotenpunkt mit einem ersten Wichtungsfaktor gewichtet die Regeldifferenz und mit einem zweiten Wichtungsfaktor gewichtet ein Rückkopplungssignal zugeführt werden,
- dass der innere Knotenpunkt ein durch Addieren von gewichteter Regeldifferenz und gewichtetem Rückkopplungssignal gebildetes inneres Summensignal dem Frequenzfilter zuführt,
- dass das Frequenzfilter eine Frequenzfilterung durchführt und das gefilterte Signal dem vorderen Pufferspeicher zuführt,
- dass der vordere Pufferspeicher eine erste Laufzeitverzögerung durchführt und das entsprechend verzögerte Signal dem hinteren Pufferspeicher zuführt,
- dass der hintere Pufferspeicher eine zweite Laufzeitverzögerung durchführt und das entsprechend verzögerte Signal als Rückkopplungssignal ausgibt,
- dass zwischen dem vorderen Pufferspeicher und dem hinteren Pufferspeicher ein innerer Abgreifpunkt angeordnet ist, an dem das Kompensationssignal abgegriffen und dem hinteren Knotenpunkt zugeführt wird, und
- dass das Frequenzfilter und die beiden Pufferspeicher derart ausgelegt sind, dass die Summe der Verzögerungszeiten von Frequenzfilter und beiden Pufferspeichern ein ganzzahliges Vielfaches der Periodendauer der Störung ist und die Summe der Verzögerungszeiten von Frequenzfilter und vorderem Pufferspeicher ein ganzzahliges Vielfaches der Periodendauer der Störung abzüglich der Laufzeit, die vergeht, bis ein dem vorderen Knotenpunkt zugeführtes Signal eine Änderung des Istwerts bewirkt, ist.

Der Kompensationskreis entspricht einem sogenannten inneren Modell der Regelstrecke. Innere Modelle sind auf dem Gebiet der Regelungstechnik bekannt.

Das Frequenzfilter kann nach Bedarf ausgebildet sein. Beispielsweise kann das Frequenzfilter als lineares nichtrekursives digitales Filter (englisch: finite impulse response = FIR) ausgebildet sein. Derartige Filter weisen für alle Frequenzen dieselbe Laufzeit auf.

Das Frequenzfilter kann insbesondere als Tiefpassfilter ausgebildet sein. Eine Filterordnung des Frequenzfilters kann fest vorgegeben oder einstellbar sein.

Mittels eines nichtrekursiven digitalen Filters können bestimmte Frequenzbereiche der Regeldifferenz gefiltert werden. In manchen Fällen ist es jedoch lediglich erforderlich, eine einzige oder einige wenige konkret spezifizierte Frequenzen zu filtern und deren Störung zu kompensieren. In einem derartigen Fall kann das Frequenzfilter - alternativ zu einer Ausgestaltung als nichtrekursives digitales Filter - eine Anzahl von orthogonalen Korrelationsfiltern aufweisen, mittels derer jeweils eine einzelne Frequenzkomponente ausgefiltert wird. Die Anzahl an orthogonalen Korrelationsfiltern beträgt in einem derartigen Fall minimal 1. Sie kann aber auch größer sein.

Der erste Wichtungsfaktor bestimmt, wie schnell der Kompensationskreis eine auftretende Störung lernt. Der zweite Wichtungsfaktor bestimmt, wie gut sich der Kompensationskreis eine einmal gelernte Störung merkt. Die Wichtungsfaktoren können fest vorgegeben sein. Vorzugsweise sind sie jedoch einstellbar.

Vorzugsweise ist der Ausgang des Frequenzfilters von dem inneren Abgreifpunkt trennbar. Insbesondere ist es bei von dem inneren Abgreifpunkt getrenntem Ausgang des Frequenzfilters auf einfache Weise möglich möglich, die Stabilität des Kompensationskreises und auch der Regelstruktur als Ganzes zu überprüfen und gegebenenfalls Parameter des Kompensationskreises - insbesondere die Filterordnung des nichtrekursiven digitalen Filters und/oder die Wichtungsfaktoren - derart einzustellen, dass der Kompensationskreis und mit ihm die gesamte Regelung auch dann stabil bleibt, wenn der Kompensationskreis geschlossen ist, der Ausgang des Frequenzfilters also mit dem inneren Abgreifpunkt verbunden ist.

Insbesondere sind vorzugsweise der erste Wichtungsfaktor, der zweite Wichtungsfaktor und das Frequenzfilter derart eingestellt, dass bei von dem inneren Abgreifpunkt getrenntem Ausgang des Frequenzfilters eine Verstärkung vom inneren Abgreifpunkt bis zum Ausgang des Frequenzfilters unabhängig von einer Frequenz eines am inneren Abgreifpunkt anstehenden Signals kleiner als oder maximal gleich 1 ist. Diese Einstellung gewährleistet - sofern der eigentliche Regelkreis als solcher stabil ist - die Stabilität der Regelstruktur als Ganzes.

Vorzugsweise ist die Verstärkung als Funktion der Frequenz über eine Ausgabeeinrichtung an einen Benutzer der Regeleinrichtung ausgebbar ist. Dadurch erhält der Benutzer eine Rückkopplung darüber, ob von ihm vorgenommene Einstellungen des Kompensationskreises die Stabilität der Regelstruktur als Ganzes gefährden oder nicht.

Es ist möglich, dass dem Regler mindestens ein weiterer Regler unterlagert ist. In diesem Fall wird vorzugsweise dem unterlagerten Regler ein aus den im vorderen Pufferspeicher abgespeicherten Signalen abgeleitetes Vorsteuersignal zugeführt. Dadurch kann die Qualität der Regelung noch weiter erhöht werden.

Die Periodendauer der Störung kann in manchen Fällen im Laufe der Zeit variieren. Insbesondere bei einer Rundachse ist die Periodendauer der Störung oftmals indirekt proportional zu einer Drehzahl der Rundachse. In einem derartigen Fall wird vorzugsweise zumindest die Verzögerungszeit des vorderen Pufferspeichers entsprechend der Periodendauer dynamisch nachgeführt.

Wie bereits erwähnt, kann die Regelstrecke als Rundachse ausgebildet sein. Wenn in einem derartigen Fall der Regler als Lageregler ausgebildet ist, ist vorzugsweise den im vorderen und im hinteren Pufferspeicher gespeicherten Signalen jeweils ein zugehöriger Lagewert zugeordnet. Dadurch ist es möglich, dass beim Variieren der Periodendauer der Kompensationskreis und im hinteren Pufferspeicher gespeicherten Signalen jeweils ein zugehöriger Lagewert zugeordnet. Dadurch ist es möglich, dass beim Variieren der Periodendauer der Kompensationskreis das Kompensationssignal unter Berücksichtigung der den im vorderen und im hinteren Pufferspeicher gespeicherten Signalen zugeordneten Lagewerte ermittelt.

In vielen Fällen ist die Regeleinrichtung als softwareprogrammierbare Regeleinrichtung ausgebildet und mit einem Softwaremodul programmiert, so dass sie aufgrund der Programmierung mit dem Softwaremodul erfindungsgemäß ausgebildet ist.

Die Aufgabe wird weiterhin durch ein softwareprogrammierbare Regeleinrichtung mit den Merkmalen des Anspruchs 14 gelöst. Erfindungsgemäß bewirkt die Abarbeitung des Maschinencodes der Softwaremoduls durch die softwareprogrammierbare Regeleinrichtung, dass die Regeleinrichtung erfindungsgemäß ausgebildet ist. Das Softwaremodul kann insbesondere auf einem Datenträger in maschinenlesbarer Form gespeichert sein.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die in Verbindung mit den Zeichnungen näher erläutert werden. Hierbei zeigen in schematischer Darstellung:

FIG 1      eine Regeleinrichtung zum Regeln einer Regelstrecke,

FIG 2      ein Zeitdiagramm einer Störung,

FIG 3      die Regeleinrichtung von FIG 1 bei geöffnetem Kompensationskreis,

FIG 4      Frequenzgänge,

FIG 5      eine Modifikation der Regeleinrichtung von FIG 1,

FIG 6      einen möglichen Aufbau eines Pufferspeichers,

FIG 7      eine weitere Modifikation der Regeleinrichtung von FIG 1,

FIG 10    eine mögliche Ausgestaltung eines Frequenzfilters und

FIG 11    eine Regeleinrichtung zum Regeln einer Regelstrecke.

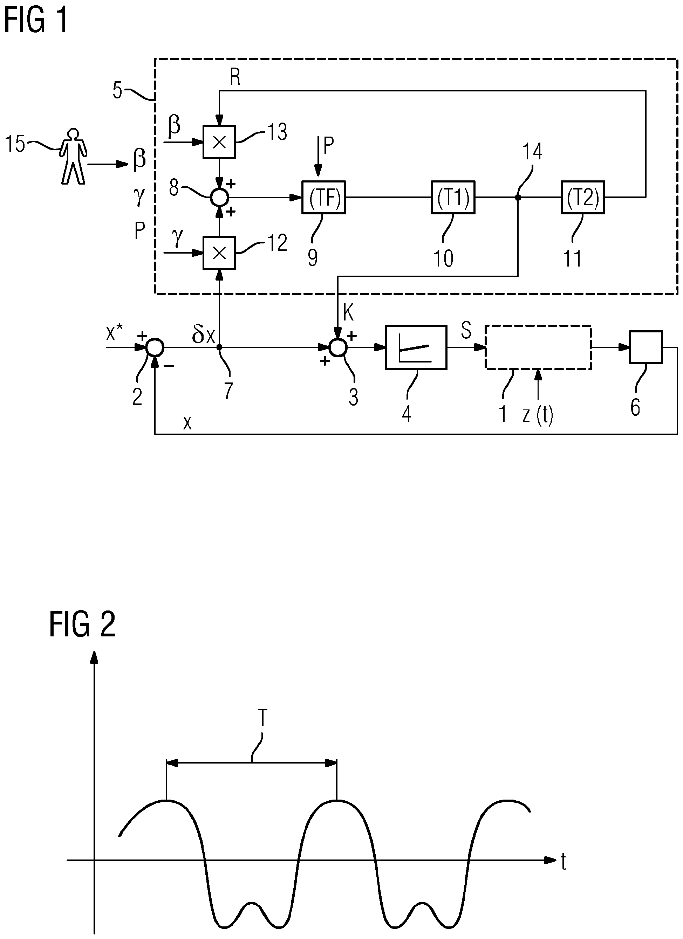

Gemäß FIG 1 weist eine Regeleinrichtung zum Regeln einer Regelstrecke 1 einen vorderen Knotenpunkt 2, einen hinteren Knotenpunkt 3, einen Regler 4 und einen Kompensationskreis 5 auf. Dem vorderen Knotenpunkt 2 werden ein Istwert x und ein korrespondierender Sollwert x* zugeführt. Der Istwert x wird ausgangsseitig der Regelstrecke 1 mittels einer Messeinrichtung 6 messtechnisch erfasst. Der vordere Knotenpunkt 2 ermittelt durch Bildung der Differenz von Sollwert x* und Istwert x eine Regeldifferenz δx. Dem hinteren Knotenpunkt 3 werden die Regeldifferenz δx und ein Kompensationssignal K zugeführt. Der hintere Knotenpunkt 3 addiert die Regeldifferenz δx und das Kompensationssignal K und bildet dadurch ein Summensignal, nachfolgend als äußeres Summensignal bezeichnet. Der hintere Knotenpunkt 3 führt das äußere Summensignal dem Regler 4 zu. Der Regler 4 ermittelt anhand des ihm zugeführten äußeren Summensignals ein Stellsignal S für die Regelstrecke 1. Der Regler 4 gibt das Stellsignal S an die Regelstrecke 1 aus.

Der erfasste Istwert x ist mit einer Störung z beaufschlagt. Die Störung z ist gemäß der Darstellung in FIG 2 eine periodische Funktion der Zeit t. Sie weist also eine Periodendauer T auf. Der Kompensation der Störung z dienen der Kompensationskreis 5 und das von dem Kompensationskreis 5 ermittelte Kompensationssignal K.

Um das Kompensationssignal K ermitteln zu können, ist zwischen dem vorderen und dem hinteren Knotenpunkt 2, 3 ein äußerer Abgreifpunkt 7 angeordnet. An dem äußeren Abgreifpunkt 7 wird die Regeldifferenz δx abgegriffen und dem Kompensationskreis 5 zugeführt. Der Kompensationskreis 5 ermittelt das Kompensationssignal K und führt es dem hinteren Knotenpunkt 3 zu.

Der Kompensationskreis 5 weist einen inneren Knotenpunkt 8, ein Frequenzfilter 9, einen vorderen Pufferspeicher 10 und einen hinteren Pufferspeicher 11 auf. Dem inneren Knotenpunkt 8 sind zwei Multiplizierer 12, 13 vorgeordnet. Dem Multiplizierer 12 wird die Regeldifferenz δx zugeführt, dem Multiplizierer 13 ein Rückkopplungssignal R. Die Multiplizierer 12, 13 multiplizieren die ihnen zugeführten Signale δx, R mit einem jeweiligen Wichtungsfaktor γ, β und führen die Produkte dem inneren Knotenpunkt 8 zu. Der innere Knotenpunkt 8 addiert die mit dem Wichtungsfaktor γ gewichtete Regeldifferenz δx und das mit dem Wichtungsfaktor β gewichtete Rückkopplungssignal R und bildet so ein weiteres Summensignal, nachfolgend als inneres Summensignal bezeichnet. Das innere Summensignal führt der innere Knotenpunkt 8 dem Frequenzfilter 9 zu.

Das Frequenzfilter 9 führt eine Frequenzfilterung durch. Das Frequenzfilter 9 kann zu diesem Zweck entsprechend der Darstellung in FIG 1 beispielsweise als nichtrekursives digitales Filter ausgebildet sein, insbesondere als Tiefpassfilter. Eine Filterordnung des Frequenzfilters 9 kann durch Einstellen entsprechender Parameter P einstellbar sein. Das Frequenzfilter 9 führt das entsprechend gefilterte Signal dem vorderen Pufferspeicher 10 zu.

Der vordere Pufferspeicher 10 führt eine erste Laufzeitverzögerung T1 des ihm zugeführten Signals durch. Das entsprechend verzögerte Signal führt der vordere Pufferspeicher 10 dem hinteren Pufferspeicher 11 zu. In analoger Weise führt der hintere Pufferspeicher 11 eine zweite Laufzeitverzögerung T2 durch. Das entsprechend verzögerte Signal gibt der hintere Pufferspeicher 11 als Rückkopplungssignal R aus.

Zwischen dem vorderen Pufferspeicher 10 und dem hinteren Pufferspeicher 11 ist ein innerer Abgreifpunkt 14 angeordnet. An dem inneren Abgreifpunkt 14 wird das Kompensationssignal K abgegriffen und dem hinteren Knotenpunkt 3 zugeführt.

Das Frequenzfilter 9 weist, wie bereits erwähnt, eine Filterordnung auf. Die Filterordnung korrespondiert mit einer Verzögerungszeit TF. Erfindungsgemäß sind das Frequenzfilter 9 und die beiden Pufferspeicher 10, 11 derart ausgelegt, dass die Beziehung

$$TF + T1 + T2 = n \cdot T \tag{1}$$

gilt. n ist eine ganze Zahl. In der Regel ist die Zahl n so klein wie möglich. Oftmals weist die Zahl n den Wert 1 oder den Wert 2 auf.

Die Regelstrecke 1 weist in Verbindung mit der normalen Regelung (d.h. ohne Kompensationskreis 5) eine Laufzeit TL auf. Die Laufzeit TL ist diejenige Zeit, die vergeht, bis ein dem vorderen Knotenpunkt 2 zugeführtes Signal eine Änderung des Istwerts x bewirkt. Der hintere Pufferspeicher 11 ist erfindungsgemäß derart ausgelegt, dass die

Beziehung

$$T2 - TL = m \cdot T \hspace{6cm} (2)$$

gilt. m ist eine ganze Zahl. In der Regel ist die Zahl m so klein wie möglich. Oftmals weist die Zahl m den Wert 0 auf. In Einzelfällen kann die Zahl m den Wert 1 aufweisen. Größere Werte sollte die Zahl m vorzugsweise nicht aufweisen. Somit ist die Summe der Verzögerungszeiten TF, T1 von Frequenzfilter 9 und vorderem Pufferspeicher 10 ein ganzzahliges Vielfaches der Periodendauer T der Störung z abzüglich der Laufzeit TL.

Der erste Wichtungsfaktor γ, und der zweite Wichtungsfaktor β sind vorzugsweise gemäß FIG 1 von einem Benutzer 15 der Regeleinrichtung einstellbar. Gleiches gilt vorzugsweise auch für die Parameter P des Frequenzfilters 9. Dadurch kann der Kompensationskreis 5 vom Benutzer 15 derart eingestellt werden, dass eine stabile Regelung der Regelstrecke 1 gewährleistet ist. Die Wichtungsfaktoren γ, β sind vorzugsweise frequenzunabhängig.

Zum Einstellen des Kompensationskreises 5 wird zunächst - wie im Stand der Technik auch - die Regeleinrichtung als solche, d.h. ohne den Kompensationskreis 5 und dessen parametrierbare Komponenten 9, 10 und 11 - parametriert, so dass die Regeleinrichtung als solche die Regelstrecke 1 stabil regelt. Diese Vorgehensweise ist Fachleuten bekannt und vertraut und muss daher nicht näher erläutert werden. Sodann wird der Kompensationskreis 5 aktiviert, das heißt dass eine regeltechnische Verbindung des inneren Abgreifpunkts 14 mit dem hinteren Knotenpunkt 5 hergestellt wird.

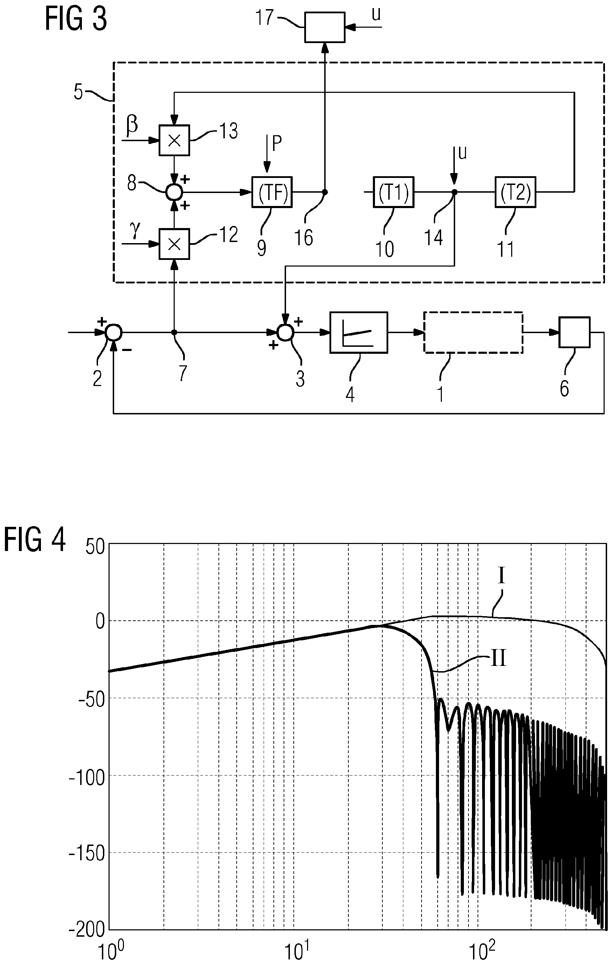

Um geeignete Einstellungen der Wichtungsfaktoren γ, β und der Parameter P des Frequenzfilters 9 zu ermitteln, wird weiterhin gemäß FIG 3 zunächst ein Ausgang 16 des Frequenzfilters 9 von dem inneren Abgreifpunkt 14 getrennt. Dieser Zustand des Kompensationskreises 5 wird nachfolgend als geöffneter Kompensationskreis 5 bezeichnet. Sodann wird in diesem Zustand (also mit geöffnetem Kompensationskreis 5) ein Signal u an den inneren Abgreifpunkt 14 angelegt und die Verstärkung ermittelt, die sich am Ausgang 16 des Frequenzfilters 9 ergibt.

FIG 4 zeigt beispielhaft die Verstärkung als Funktion der Frequenz. Nach rechts ist in FIG 4 in logarithmischem Maßstab die Frequenz aufgetragen, nach oben die Verstärkung in Dezibel. Wie aus FIG 4 ersichtlich ist, hängt die Verstärkung von der Frequenz des Signals u und von den Einstellungen der Wichtungsfaktoren γ, β und der Parameter P des Frequenzfilters 9 ab. Wenn beispielsweise die Wichtungsfaktoren γ und β beide den Wert 1 aufweisen und das Frequenzfilter 9 derart parametriert ist, dass es keinerlei Filterung durchführt, sondern als reiner Pufferspeicher wirkt, ist die Verstärkung - siehe in FIG 4 die mit I bezeichnete Kurve - bei manchen Frequenzen größer als 1. Wenn hingegen die Wichtungsfaktoren γ und/oder β kleinere Werte annehmen - beispielsweise zwischen 0,6 und 0,8 liegen - und/oder das Frequenzfilter 9 als Tiefpassfilter parametriert ist, kann - siehe in FIG 4 die mit II bezeichnete Kurve - gewährleistet werden, dass die Verstärkung unabhängig von der Frequenz des Signals u stets kleiner als oder maximal gleich 1 ist. Mit einer derartigen Parametrierung bleibt die Regeleinrichtung auch dann stabil, wenn das am Ausgang 16 des Frequenzfilters 9 anstehende Signal über den vorderen Pufferspeicher 10 dem inneren Abgreifpunkt 14 (und von dort aus dem hinteren Pufferspeicher 11) zugeführt wird.

Die Verstärkung als Funktion der Frequenz des Signals u wird oftmals auch als Übertragungsfunktion bezeichnet. Vorzugsweise ist die Übertragungsfunktion gemäß FIG 3 über eine Anzeigeeinrichtung 17 an den Benutzer 15 der Regeleinrichtung ausgebbar. Der Benutzer 15 kann daher bei geöffnetem Kompensationskreis 5 die Wichtungsfaktoren γ, β und die Parameter P des Frequenzfilters 9 einstellen, die sich ergebende Übertragungsfunktion zur Kenntnis nehmen und sodann nach Bedarf die Wichtungsfaktoren γ, β und die Parameter P des Frequenzfilters 9 variieren, bis die Verstärkung unabhängig von der Frequenz des Signals u stets kleiner als oder maximal gleich 1 ist.

Im Einzelfall ist es möglich, dass die Übertragungsfunktion für alle Frequenzen kleiner als 1 ist, obwohl das Frequenzfilter 9 derart parametriert ist, dass es gar keine Filterung vornimmt, sondern lediglich als (weiterer) Pufferspeicher wirkt. In diesem Fall ist das Frequenzfilter 9 entartet. In der Regel ist jedoch eine (echte) Filterung erforderlich. Insbesondere kann das Frequenzfilter 9 derart parametriert werden, dass es genau in den Frequenzbereichen, in denen die Übertragungsfunktion anderenfalls größer als 1 wäre, die Verstärkung dämpft.

Vorzugsweise erfolgt die Parametrierung des Frequenzfilters 9 derart, dass die Filterordnung möglichst niedrig ist. Denn dadurch verbessert sich das Verhalten des Kompensationskreises 5 bei höheren Frequenzen der Störung z. Weiterhin wird in der Regel versucht, die sogenannte Knickfrequenz des Frequenzfilters 9 so hoch wie möglich einzustellen.

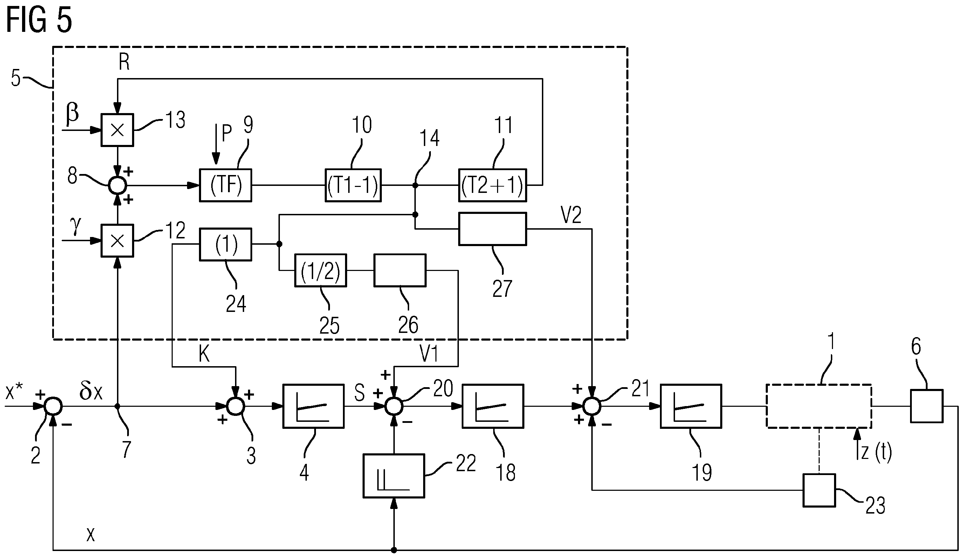

In vielen Fällen ist die Regeleinrichtung als kaskadierte Regeleinrichtung ausgebildet. Beispielsweise kann im Falle einer Ausgestaltung des Reglers 4 als Geschwindigkeits- oder Drehzahlregler dem Regler 4 ein Beschleunigungs-, Moment- oder Stromregler unterlagert sein. In analoger Weise kann im Falle einer Ausgestaltung des Reglers 4 als Lageregler dem Regler 4 ein Geschwindigkeits- oder Drehzahlregler oder ein Beschleunigungs-, Moment- oder Stromregler unterlagert sein. FIG 5 zeigt eine Ausgestaltung, in welcher der Regler 4 als Lageregler ausgebildet ist, dem ein Geschwindigkeits- oder Drehzahlregler 18 unterlagert ist. Dem Geschwindigkeits- oder Drehzahlregler 18 seinerseits ist ein Beschleunigungs-, Moment- oder Stromregler 19 unterlagert.

Im Falle des Vorhandenseins von unterlagerten Reglern 18, 19 ist dem jeweiligen unterlagerten Regler 18, 19 ein jeweiliger Knotenpunkt 20, 21 vorgeordnet. Dem jeweiligen Knotenpunkt 20, 21 wird einerseits als Sollwert das Ausgangssignal des jeweils überlagerten Reglers 4, 18 und der zugehörige Istwert zugeführt. Beispielsweise kann der Istwert für den Geschwindigkeits- oder Drehzahlregler 18 mittels eines Differenzierers 22 aus dem Lageistwert x abgeleitet werden. Ein Istwert für den Stromregler 19 kann beispielsweise mittels einer entsprechenden Messeinrichtung 23 erfasst werden.

Im Falle der Ausgestaltung der Regeleinrichtung als kaskadierte Regeleinrichtung kann entsprechend der Darstellung in FIG 5 analog zu FIG 1 eine Kompensation mittels des Kompensationssignals K erfolgen. Zusätzlich ist es jedoch möglich, dem unterlagerten Regler 18 ein Vorsteuersignal V1 zuzuführen, dem unterlagerten Regler 19 ein Vorsteuersignal V2 zuzuführen oder beiden unterlagerten Reglern 18, 19 ein jeweiliges Vorsteuersignal V1, V2 zuzuführen. Die Vorsteuersignale V1, V2 für die unterlagerten Regler 18, 19 werden gemäß FIG 5 aus den Signalen abgeleitet, die im vorderen Pufferspeicher 10 gespeichert sind.

Insbesondere sind entsprechend der Darstellung in FIG 5 die Pufferspeicher 9, 10 gegenüber der Darstellung in FIG 1 geringfügig modifiziert. Weiterhin weist der Kompensationskreis 5 zusätzliche Pufferspeicher 24, 25 auf. Schließlich weist der Kompensationskreis 5 Ermittlungselemente 26, 27 auf.

Die Modifikation der Pufferspeicher 9, 10 besteht darin, dass der vordere Pufferspeicher 9 geringfügig verkürzt ist - in der Regel um eine Speicherzelle. Diese Verkürzung korrespondiert, weil die gesamte Regeleinrichtung in der Regel getaktet betrieben wird, mit einer Verkürzung um einen Taktzyklus. Der hintere Pufferspeicher 10 ist um das gleiche Ausmaß verlängert. Die Summe der Laufzeitverzögerungen T1, T2 von vorderem und hinterem Pufferspeicher 9, 10 ist also unverändert.

Der zusätzliche Pufferspeicher 24 weist exakt die Länge auf, um welche der vordere Pufferspeicher 9 verkürzt ist. Das Aufschalten des Kompensationssignals K erfolgt somit bei der Ausgestaltung gemäß FIG 5 exakt zu dem gleichen Zeitpunkt wie bei der Ausgestaltung gemäß FIG 1.

Das Ermittlungselement 26 nimmt diejenigen Ermittlungen vor, die zur Ermittlung des Vorsteuersignals V1 erforderlich sind. Hierfür wird in der Regel eine Ermittlungszeit nötigt. Der zusätzliche Pufferspeicher 25 ist derart dimensioniert, dass er eine Verzögerung bewirkt, die in Verbindung mit der durch das Ermittlungselement 26 bewirkten Verzögerung der Länge des zusätzlichen Pufferspeichers 24 entspricht.

Das Ermittlungselement 27 nimmt diejenigen Ermittlungen vor, die zur Ermittlung des Vorsteuersignals V2 erforderlich sind. Hierfür wird in der Regel ebenfalls eine Ermittlungszeit nötigt. Diese Ermittlungszeit ist in der Regel größer als die Ermittlungszeit des Ermittlungselements 26.

Dem Ermittlungselement 27 ist kein Pufferspeicher vor- oder nachgeordnet. Dies ist dadurch möglich, dass der zusätzliche Pufferspeicher 24 derart dimensioniert, dass seine Verzögerung mit der Ermittlungszeit des Ermittlungselements 27 korrespondiert.

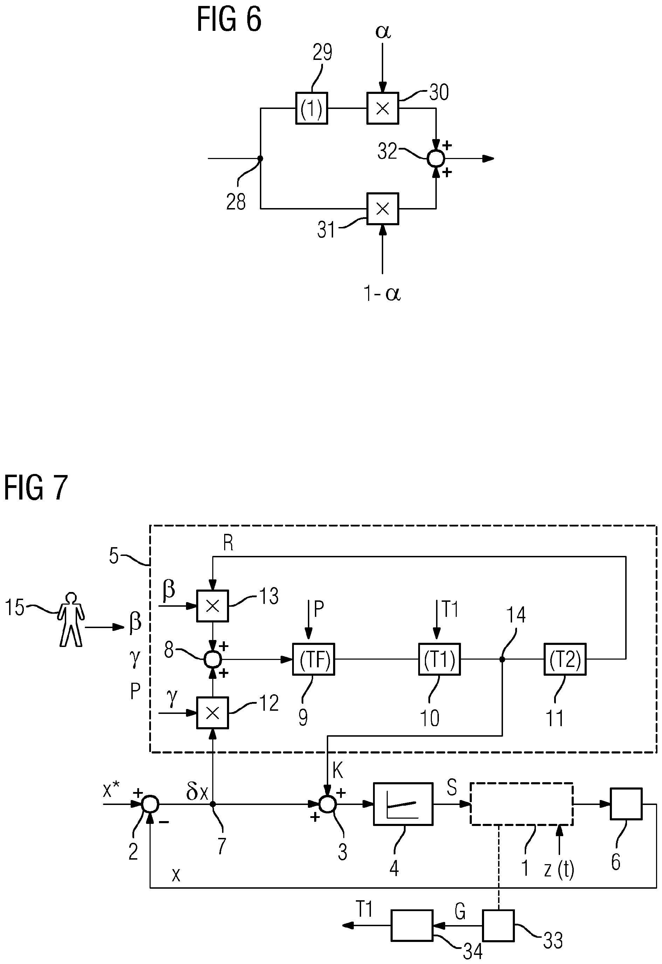

Die Ermittlungszeiten der Ermittlungselemente 26, 27 können im Einzelfall mit ganzzahligen Vielfachen des Taktzyklus korrespondieren. Oftmals korrespondieren die Ermittlungszeiten jedoch nur mit ganzzahligen Vielfachen der Hälfte des Taktzyklus. Insbesondere ist es möglich, das die Ermittlungszeit des Ermittlungselements 26 mit einem halben Taktzyklus korrespondiert und die Ermittlungszeit des Ermittlungselements 27 mit einem vollen Taktzyklus korrespondiert. In einem derartigen Fall muss der zusätzliche Pufferspeicher 25 eine Verzögerung um einen halben Taktzyklus realisieren. Um eine derartige Verzögerung (oder auch eine andere Verzögerung, die von einem vollen Taktzyklus verschieden ist) realisieren zu können, wird der zusätzlich Pufferspeicher 25 so ausgestaltet, wie dies nachfolgend in Verbindung mit FIG 6 näher erläutert wird. In Verbindung mit FIG 6 wird hierbei nur erläutert, wie der Pufferspeicher 25 ausgestaltet werden muss, um im Ergebnis eine Verzögerung zwischen 0 und einem vollen Taktzyklus realisieren zu können. Dies ist hinreichend, weil eine Realisierung von vollen Taktzyklen schlichtweg durch eine entsprechende Anzahl von Speicherzellen des Pufferspeichers 25 realisiert werden kann. Weiterhin können selbstverständlich auch andere Pufferspeicher als der Pufferspeicher 25 durch eine Ausgestaltung analog zu FIG 6 eine Verzögerung zwischen 0 und einem vollen Taktzyklus realisieren.

Gemäß FIG 6 weist der Pufferspeicher 25 einen Knotenpunkt 28, eine einzelne Speicherzelle 29, zwei Multiplizierer 30, 31 und einen Knotenpunkt 32 auf. Am Knotenpunkt 28 wird das dem Pufferspeicher 25 zugeführte Signal den beiden Zweigen zugeführt, von denen einer die Speicherzelle 29 und den einen Multiplizierer 30 und der andere den Multiplizierer 31 enthält. Die Speicherzelle 29 bewirkt eine Verzögerung um einen vollen Taktzyklus. Den Multiplizierern 30, 31 werden Wichtungsfaktoren $\alpha$ und $1-\alpha$ zugeführt. Am Knotenpunkt 32 erfolgt eine Summation der beiden gewichteten Signale. Im Ergebnis bewirkt die Struktur gemäß FIG 6 eine Verzögerung um $\alpha$ Bruchteile eines Taktzyklus.

In manchen Fällen ist die Periodendauer T konstant. In anderen Fällen variiert die Periodendauer T im Laufe der Zeit t. Wenn die Periodendauer T im Laufe der Zeit t variiert, wird die Regeleinrichtung von FIG 1 vorzugsweise entsprechend der Ausgestaltung gemäß FIG 7 modifiziert. Eine analoge Modifikation wäre auch bezüglich der Regeleinrichtung von FIG 5 möglich.

Gemäß FIG 7 wird mittels einer Messeinrichtung 33 eine Größe G erfasst, welche charakteristisch für die Periodendauer T ist. Die Größe G wird einer Ermittlungseinrichtung 34 zugeführt, welche daraus die erste Verzögerungszeit T1 des vorderen Pufferspeichers 10 ermittelt und den vorderen Pufferspeicher 10 dynamisch entsprechend konfiguriert. Die erste Verzögerungszeit T1 wird somit dynamisch nachgeführt. Die Größe G als solche kann nach Bedarf bestimmt sein. Wenn die Regelstrecke 1 beispielsweise als Antrieb ausgebildet ist, kann in manchen Fällen die Frequenz der Störung z proportional zu einer Drehzahl des Antriebs sein. In diesem Fall ist die Periodendauer T reziprok zur Drehzahl. Wenn in einem derartigen Fall mittels der Messeinrichtung 33 die Drehzahl erfasst wird, kann dadurch auf die Periodendauer T rückgeschlossen werden.

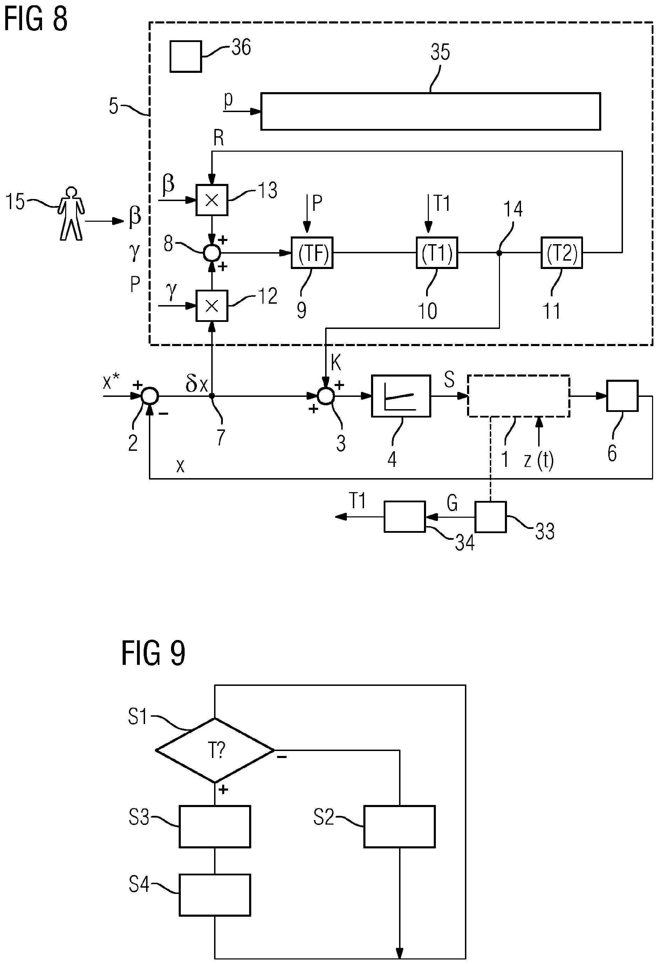

In vielen Fällen ist die Regelstrecke 1 als Rundachse ausgebildet, also als Achse, die rotiert und deren physikalischer Zustand sich somit mit jeder vollen Umdrehung wiederholt. Weiterhin ist in derartigen Fällen der Regler 4 oftmals als Lageregler ausgebildet. Wenn in derartigen Fällen die Drehzahl der Rundachse und damit die Periodendauer T variieren kann, wird die Regeleinrichtung von FIG 1 vorzugsweise so modifiziert, wie dies nachfolgend in Verbindung mit FIG 8 näher erläutert wird. Analoge Modifikationen wären auch bezüglich der Regeleinrichtungen von FIG 5 und FIG 7 möglich.

Gemäß FIG 8 wird dem Kompensationskreis 5 zusätzlich zur Regelabweichung $\delta x$ jeweils auch ein zugehöriger Lagewert p zugeführt. Der Lagewert p kann mit dem Sollwert x*, dem Istwert x oder einer Kombination der beiden Werte x*, x korrespondieren. Der Kompensationskreis 5 weist zusätzlich ein Schieberegister 35 auf, in das die Lagewerte p eingeschrieben werden. Das Einschreiben der Lagewerte p erfolgt synchron mit dem Übernehmen der Regelabweichung $\delta x$ in das Frequenzfilter 9. Somit ist insbesondere den im vorderen und im hinteren Pufferspeichern 10, 11 gespeicherten Signalen (genau genommen auch den innerhalb des Frequenzfilters 9 verarbeiteten Signalen) jeweils ein zugehöriger Lagewert p zugeordnet.

Im Falle der Ausgestaltung gemäß FIG 8 prüft eine Steuereinrichtung 36 des Kompensationskreises 5 gemäß FIG 9 in einem Schritt S1, ob die Periodendauer T der Störung z sich geändert hat. Wenn dies nicht der Fall ist, geht die Steuereinrichtung 36 zu einem Schritt S2 über. Im Schritt S2 wird so verfahren, wie obenstehend in Verbindung mit FIG 1 erläutert wurde. Wenn die Periodendauer T der Störung z sich hingegen geändert hat, die Periodendauer T also variiert wurde, geht die Steuereinrichtung 36 zu einem Schritt S3 über. Im Schritt S3 ermittelt die Steuereinrichtung 36 unter Berücksichtigung der im Schieberegister 35 gespeicherten Lagewerte p diejenige Stelle im vorderen oder im hinteren Pufferspeicher 10, 11, dessen dort gespeichertes Signal als Kompensationssignal K dem hinteren Knotenpunkt 3 zugeführt werden soll. Das entsprechende Signal wird in einem Schritt S4 dem hinteren Knotenpunkt 3 zugeführt.

Die Vorgehensweise von FIG 9 führt in aller Regel auch dann zu guten Ergebnissen, wenn die Periodendauer T sich relativ rasch ändert. Dies gilt insbesondere dann, wenn die korrekte Stelle im vorderen und hinteren Pufferspeicher 10, 11 im Rahmen einiger weniger Iterationen (beispielsweise 3 bis 5 Iterationen) ermittelt wird.

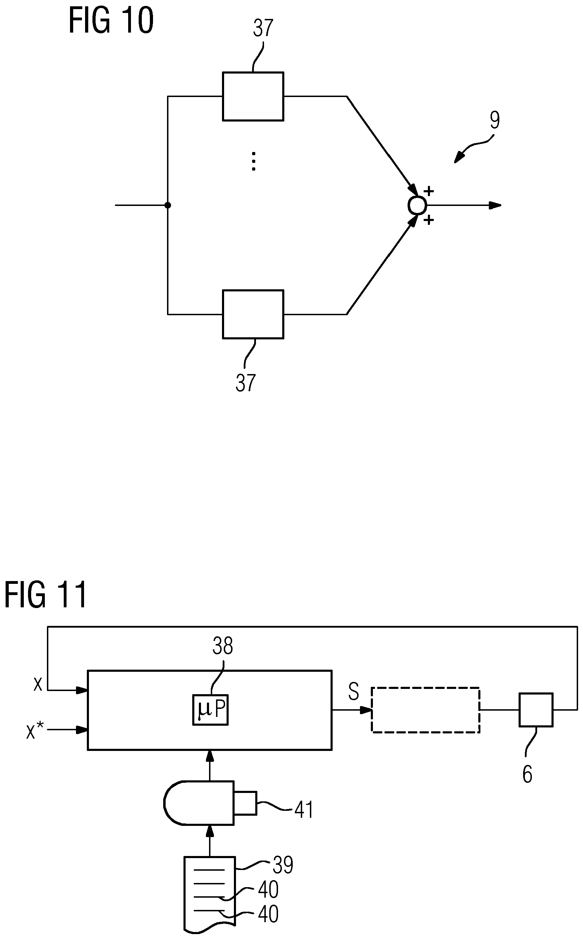

Obenstehend wurde die vorliegende Erfindung in Verbindung mit einem Frequenzfilter 9 erläutert, das als nichtrekursives digitales Filter ausgebildet ist. Das Frequenzfilter 9 kann jedoch entsprechend der Darstellung in FIG 10 alternativ eine Anzahl von orthogonalen Korrelationsfiltern 37 aufweisen, mittels derer jeweils eine einzelne Frequenzkomponente ausgefiltert wird. Orthogonale Korrelationsfilter 37 berechnen die Koeffizienten von Fourierreihen durch orthogonale Korrelation und erzeugen dann das monofrequente und phasenrichtige Signal. Der Aufbau und die Wirkungsweise von orthogonalen Korrelationsfiltern 37 sind Fachleuten allgemein bekannt und müssen daher nicht näher erläutert werden.

Die Anzahl an orthogonalen Korrelationsfiltern 37 kann nach Bedarf bestimmt sein. Minimal ist gegebenenfalls ein einziges orthogonales Korrelationsfilter 37 vorhanden. Wenn mehrere orthogonale Korrelationsfilter 37 vorhanden sind, sind diese einander entsprechend der Darstellung in FIG 10 parallel geschaltet.

Die Regeleinrichtung ist vorzugsweise entsprechend der Darstellung in FIG 11 als softwareprogrammierbare Regeleinrichtung ausgebildet. Sie umfasst also einen Mikroprozessor 38. Die Regeleinrichtung ist in diesem Fall mit einem Softwaremodul 39 programmiert. Aufgrund der Programmierung mit dem Softwaremodul 39 ist die Regeleinrichtung erfindungsgemäß ausgebildet. Das Softwaremodul 39 umfasst Maschinencode 40. Die Abarbeitung des Maschinencodes 40 durch die Regeleinrichtung bewirkt somit, dass die Regeleinrichtung erfindungsgemäß ausgebildet ist.

Das Softwaremodul 39 kann der Regeleinrichtung auf prinzipiell beliebige Weise zugeführt werden. Insbesondere kann das Softwaremodul 39 auf einem Datenträger 41 in maschinenlesbarer Form gespeichert sein. Die Darstellung in FIG 11, in welcher der Datenträger 41 als USB-Memorystick dargestellt ist, ist jedoch rein beispielhaft und nicht beschränkend zu verstehen.

Zusammengefasst betrifft die vorliegende Erfindung somit folgenden Sachverhalt:
Eine Regeleinrichtung zum Regeln einer Regelstrecke 1 weist einen vorderen Knotenpunkt 2, einen hinteren Knotenpunkt 3, einen Regler 4 und einen Kompensationskreis 5 auf. Dem vorderen Knotenpunkt 2 werden ein ausgangsseitig der Regelstrecke 1 erfasster Istwert x und ein korrespondierender Sollwert x* zugeführt. Er ermittelt eine Regeldifferenz $\delta x$. Der erfasste Istwert x ist mit einer Störung z beaufschlagt. Dem hinteren Knotenpunkt 3 werden die Regeldifferenz $\delta x$ und ein Kompensationssignal K zugeführt. Er führt ein aus Regeldifferenz $\delta x$ und Kompensationssignal K gebildetes äußeres Summensignal dem Regler 4 zu. Der Regler 4 ermittelt ein Stellsignal S für die Regelstrecke 1 und gibt es an die Regelstrecke 1 aus. Zwischen dem vorderen und dem hinteren Knotenpunkt 2, 3 ist ein äußerer Abgreifpunkt 7 angeordnet, an dem die Regeldifferenz δx abgegriffen und dem Kompensationskreis 5 zugeführt wird. Der Kompensationskreis 5 ermittelt das Kompensationssignal K und führt es dem hinteren Knotenpunkt 3 zu. Der Kompensationskreis 5 weist einen inneren Knotenpunkt 8, ein Frequenzfilter 9, einen vorderen Pufferspeicher 10 und einen hinteren Pufferspeicher 11 auf. Dem inneren Knotenpunkt 8 werden mit Wichtungsfaktoren γ, β gewichtet die Regeldifferenz δx und ein Rückkopplungssignal R zugeführt. Der innere Knotenpunkt 8 führt ein daraus gebildetes inneres Summensignal dem Frequenzfilter 9 zu. Das Frequenzfilter 9 führt eine Frequenzfilterung durch und führt das gefilterte Signal dem vorderen Pufferspeicher 10 zu. Die Pufferspeicher 10, 11 führen eine jeweilige Laufzeitverzögerung T1, T2 durch und führen das entsprechend verzögerte Signal dem hinteren Pufferspeicher 11 zu bzw. geben es als Rückkopplungssignal R aus. Zwischen den Pufferspeichern 10, 11 ist ein innerer Abgreifpunkt 14 angeordnet, an dem das Kompensationssignal K abgegriffen wird.

Die Summe der Verzögerungszeiten TF, T1, T2 von Frequenzfilter 9 und beiden Pufferspeichern 10, 11 ist ein ganzzahliges Vielfaches der Periodendauer T der Störung z. Die Summe der Verzögerungszeiten TF, T1 von Frequenzfilter 9 und vorderem Pufferspeicher 10 ist ein ganzzahliges Vielfaches der Periodendauer T der Störung z abzüglich der Laufzeit TL, die vergeht, bis ein dem vorderen Knotenpunkt 2 zugeführtes Signal eine Änderung des Istwerts x bewirkt.

Die vorliegende Erfindung weist viele Vorteile auf. Insbesondere lassen sich periodische Störungen nahezu vollständig ausregeln. Für den Entwurf des Frequenzfilters 9 können die bekannten klassischen Fensterfunktionen verwendet werden, wie sie aus der digitalen Signalverarbeitung bekannt sind. Durch Überprüfen der Übertragungsfunktion bei geöffnetem Kompensationskreis kann weiterhin die Stabilität der Regelung vorab überprüft werden.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Regeleinrichtung zum Regeln einer Regelstrecke (1),

   - wobei die Regeleinrichtung einen vorderen Knotenpunkt (2), einen hinteren Knotenpunkt (3), einen Regler (4) und einen Kompensationskreis (5) aufweist,
   - wobei dem vorderen Knotenpunkt (2) ein ausgangsseitig der Regelstrecke (1) mittels einer Messeinrichtung (6) erfasster Istwert (x) und ein korrespondierender Sollwert (x*) zugeführt werden und der vordere Knotenpunkt (2) durch Differenzbildung von Sollwert (x*) und Istwert (x) eine Regeldifferenz (δx) ermittelt,
   - wobei der erfasste Istwert (x) mit einer eine Periodendauer (T) aufweisenden Störung (z) beaufschlagt ist, **dadurch gekennzeichnet dass**:
   - dem hinteren Knotenpunkt (3) die Regeldifferenz (δx) und ein Kompensationssignal (K) zugeführt werden und der hintere Knotenpunkt (3) ein durch Addieren von Regeldifferenz (δx) und Kompensationssignal (K) gebildetes äußeres Summensignal dem Regler (4) zuführt,
   - wobei der Regler (4) anhand des ihm zugeführten äußeren Summensignals ein Stellsignal (S) für die Regelstrecke (1) ermittelt und an die Regelstrecke (1) ausgibt,
   - wobei zwischen dem vorderen und dem hinteren Knotenpunkt (2, 3) ein äußerer Abgreifpunkt (7) angeordnet ist, an dem die Regeldifferenz (δx) abgegriffen und dem Kompensationskreis (5) zugeführt wird,
   - wobei der Kompensationskreis (5) das Kompensationssignal (K) ermittelt und dem hinteren Knotenpunkt (3) zuführt,
   - wobei der Kompensationskreis (5) einen inneren Knotenpunkt (8), ein Frequenzfilter (9), einen vorderen Pufferspeicher (10) und einen hinteren Pufferspeicher (11) aufweist,
   - wobei dem inneren Knotenpunkt (8) mit einem ersten Wichtungsfaktor (γ) gewichtet die Regeldifferenz (δx) und mit einem zweiten Wichtungsfaktor (β) gewichtet ein Rückkopplungssignal (R) zugeführt werden,
   - wobei der innere Knotenpunkt (8) ein durch Addieren von gewichteter Regeldifferenz (δx) und gewichtetem Rückkopplungssignal (R) gebildetes inneres Summensignal dem Frequenzfilter (9) zuführt,
   - wobei das Frequenzfilter (9) eine Frequenzfilterung durchführt und das gefilterte Signal dem vorderen Pufferspeicher (10) zuführt,
   - wobei der vordere Pufferspeicher (10) eine erste Laufzeitverzögerung (T1) durchführt und das entsprechend verzögerte Signal dem hinteren Pufferspeicher (11) zuführt,
   - wobei der hintere Pufferspeicher (11) eine zweite Laufzeitverzögerung (T2) durchführt und das entsprechend verzögerte Signal als Rückkopplungssignal (R) ausgibt,
   - wobei zwischen dem vorderen Pufferspeicher (10) und dem hinteren Pufferspeicher (11) ein innerer Abgreifpunkt (14) angeordnet ist, an dem das Kompensationssignal (K) abgegriffen und dem hinteren Knotenpunkt (3) zugeführt wird, und

- wobei das Frequenzfilter (9) und die beiden Pufferspeicher (10, 11) derart ausgelegt sind, dass die Summe der Verzögerungszeiten (TF, T1, T2) von Frequenzfilter (9) und beiden Pufferspeichern (10, 11) ein ganzzahliges Vielfaches der Periodendauer (T) der Störung (z) ist und die Summe der Verzögerungszeiten (TF, T1) von Frequenzfilter (9) und vorderem Pufferspeicher (10) ein ganzzahliges Vielfaches der Periodendauer (T) der Störung (z) abzüglich der Laufzeit (TL), die vergeht, bis ein dem vorderen Knotenpunkt (2) zugeführtes Signal eine Änderung des Istwerts (x) bewirkt, ist.

2.  Regeleinrichtung nach Anspruch 1,
    **dadurch gekennzeichnet,**
    **dass** das Frequenzfilter (9) als nichtrekursives digitales Filter ausgebildet ist.

3.  Regeleinrichtung nach Anspruch 2,
    **dadurch gekennzeichnet,**
    **dass** das Frequenzfilter (9) als Tiefpassfilter ausgebildet ist.

4.  Regeleinrichtung nach Anspruch 2 oder 3,
    **dadurch gekennzeichnet,**
    **dass** eine Filterordnung des Frequenzfilters (9) einstellbar ist.

5.  Regeleinrichtung nach Anspruch 1,
    **dadurch gekennzeichnet,**
    **dass** das Frequenzfilter (9) eine Anzahl von orthogonalen Korrelationsfiltern (36) aufweist, mittels derer jeweils eine einzelne Frequenzkomponente ausgefiltert wird.

6.  Regeleinrichtung nach einem der obigen Ansprüche,
    **dadurch gekennzeichnet,**
    **dass** der ersten Wichtungsfaktor ($\gamma$) und der zweiten Wichtungsfaktor ($\beta$) einstellbar sind.

7.  Regeleinrichtung nach einem der obigen Ansprüche,
    **dadurch gekennzeichnet,**
    **dass** der Ausgang (16) des Frequenzfilters (9) von dem inneren Abgreifpunkt (14) trennbar ist.

8.  Regeleinrichtung nach Anspruch 7,
    **dadurch gekennzeichnet,**
    **dass** der erste Wichtungsfaktor ($\gamma$), der zweite Wichtungsfaktor ($\beta$) und das Frequenzfilter (9) derart eingestellt sind, dass bei von dem inneren Abgreifpunkt (14) getrenntem Ausgang (16) des Frequenzfilters (9) eine Verstärkung vom inneren Abgreifpunkt (14) bis zum Ausgang (16) des Frequenzfilters (9) unabhängig von einer Frequenz eines am inneren Abgreifpunkt (14) anstehenden Signals (u) kleiner als oder maximal gleich 1 ist.

9.  Regeleinrichtung nach Anspruch 8,
    **dadurch gekennzeichnet,**
    **dass** die Verstärkung als Funktion der Frequenz über eine Ausgabeeinrichtung (17) an einen Benutzer (15) der Regeleinrichtung ausgebbar ist.

10. Regeleinrichtung nach einem der obigen Ansprüche,
    **dadurch gekennzeichnet,**
    **dass** dem Regler (4) mindestens ein weiterer Regler (18, 19) unterlagert ist und dass dem unterlagerten Regler (18, 19) ein aus den im vorderen Pufferspeicher (10) abgespeicherten Signalen abgeleitetes Vorsteuersignal (V1, V2) zugeführt wird.

11. Regeleinrichtung nach einem der obigen Ansprüche,
    **dadurch gekennzeichnet,**
    **dass** die Periodendauer (T) im Laufe der Zeit (t) variiert und dass zumindest die Verzögerungszeit (T1) des vorderen Pufferspeichers (10) entsprechend der Periodendauer (T) dynamisch nachgeführt wird.

12. Regeleinrichtung nach Anspruch 11,
    **dadurch gekennzeichnet,**
    **dass** die Regelstrecke (1) als Rundachse ausgebildet ist, dass der Regler (4) als Lageregler ausgebildet ist, dass den im vorderen und im hinteren Pufferspeicher (10, 11) gespeicherten Signalen jeweils ein zugehöriger Lagewert (p) zugeordnet ist und dass beim Variieren der Periodendauer (T) der Kompensationskreis (5) das Kompensationssignal (K) unter Berücksichtigung der den im vorderen und im hinteren Pufferspeicher (10, 11) gespeicherten Signalen zugeordneten Lagewerte (p) ermittelt.

**13.** Regeleinrichtung nach einem der obigen Ansprüche,
**dadurch gekennzeichnet,**
**dass** sie als softwareprogrammierbare Regeleinrichtung ausgebildet ist und mit einem Softwaremodul (39) programmiert ist, so dass sie aufgrund der Programmierung mit dem Softwaremodul (39) nach einem der obigen Ansprüche ausgebildet ist.

**14.** Softwareprogrammierbare Regeleinrichtung zum Regeln einer Regelstrecke (1),

- wobei die Regeleinrichtung einen Mikroprozessor (38) umfasst, der mit einem Softwaremodul (39) derart programmiert ist,
- dass die Regeleinrichtung einen vorderen Knotenpunkt (2), einen hinteren Knotenpunkt (3), einen Regler (4) und einen Kompensationskreis (5) aufweist,
- dass dem vorderen Knotenpunkt (2) ein ausgangsseitig der Regelstrecke (1) mittels einer Messeinrichtung (6) erfasster Istwert (x) und ein korrespondierender Sollwert (x*) zugeführt werden und der vordere Knotenpunkt (2) durch Differenzbildung von Sollwert (x*) und Istwert (x) eine Regeldifferenz ($\delta$x) ermittelt,
- dass der erfasste Istwert (x) mit einer eine Periodendauer (T) aufweisenden Störung (z) beaufschlagt ist,
**dadurch gekennzeichnet:**
- **dass** dem hinteren Knotenpunkt (3) die Regeldifferenz ($\delta$x) und ein Kompensationssignal (K) zugeführt werden und der hintere Knotenpunkt (3) ein durch Addieren von Regeldifferenz ($\delta$x) und Kompensationssignal (K) gebildetes äußeres Summensignal dem Regler (4) zuführt,
- **dass** der Regler (4) anhand des ihm zugeführten äußeren Summensignals ein Stellsignal (S) für die Regelstrecke (1) ermittelt und an die Regelstrecke (1) ausgibt,
- **dass** zwischen dem vorderen und dem hinteren Knotenpunkt (2, 3) ein äußerer Abgreifpunkt (7) angeordnet ist, an dem die Regeldifferenz ($\delta$x) abgegriffen und dem Kompensationskreis (5) zugeführt wird,
- **dass** der Kompensationskreis (5) das Kompensationssignal (K) ermittelt und dem hinteren Knotenpunkt (3) zuführt,
- **dass** der Kompensationskreis (5) einen inneren Knotenpunkt (8), ein Frequenzfilter (9), einen vorderen Pufferspeicher (10) und einen hinteren Pufferspeicher (11) aufweist,
- **dass** dem inneren Knotenpunkt (8) mit einem ersten Wichtungsfaktor ($\gamma$) gewichtet die Regeldifferenz ($\delta$x) und mit einem zweiten Wichtungsfaktor ($\beta$) gewichtet ein Rückkopplungssignal (R) zugeführt werden,
- **dass** der innere Knotenpunkt (8) ein durch Addieren von gewichteter Regeldifferenz ($\delta$x) und gewichtetem Rückkopplungssignal (R) gebildetes inneres Summensignal dem Frequenzfilter (9) zuführt,
- **dass** das Frequenzfilter (9) eine Frequenzfilterung durchführt und das gefilterte Signal dem vorderen Pufferspeicher (10) zuführt,
- **dass** der vordere Pufferspeicher (10) eine erste Laufzeitverzögerung (T1) durchführt und das entsprechend verzögerte Signal dem hinteren Pufferspeicher (11) zuführt,
- **dass** der hintere Pufferspeicher (11) eine zweite Laufzeitverzögerung (T2) durchführt und das entsprechend verzögerte Signal als Rückkopplungssignal (R) ausgibt,
- **dass** zwischen dem vorderen Pufferspeicher (10) und dem hinteren Pufferspeicher (11) ein innerer Abgreifpunkt (14) angeordnet ist, an dem das Kompensationssignal (K) abgegriffen und dem hinteren Knotenpunkt (3) zugeführt wird, und
- **dass** das Frequenzfilter (9) und die beiden Pufferspeicher (10, 11) derart ausgelegt sind, dass die Summe der Verzögerungszeiten (TF, T1, T2) von Frequenzfilter (9) und beiden Pufferspeichern (10, 11) ein ganzzahliges Vielfaches der Periodendauer (T) der Störung (z) ist und die Summe der Verzögerungszeiten (TF, T1) von Frequenzfilter (9) und vorderem Pufferspeicher (10) ein ganzzahliges Vielfaches der Periodendauer (T) der Störung (z) abzüglich der Laufzeit (TL), die vergeht, bis ein dem vorderen Knotenpunkt (2) zugeführtes Signal eine Änderung des Istwerts (x) bewirkt, ist.

**15.** Softwareprogrammierbare Regeleinrichtung nach Anspruch 14,
**dadurch gekennzeichnet,**
**dass** das Softwaremodul (39) auf einem Datenträger (41) in maschinenlesbarer Form gespeichert ist.

**Claims**

1. Control facility for controlling a controlled system (1),

   - wherein the control facility comprises a front nodal point (2), a rear nodal point (3), a controller (4) and a compensation circuit (5),
   - wherein an actual value (x) acquired by means of a measuring facility (6) on the output side of the controlled system (1) and a corresponding target value (x*) are supplied to the front nodal point (2) and the front nodal point (2) determines a control deviation (δx) by differentiating between the target value (x*) and the actual value (x),
   - wherein the acquired actual value (x) is subjected to a malfunction (z) comprising a cycle duration (T),
   **characterised in that**
   - the control deviation (δx) and a compensation signal (K) are supplied to the rear nodal point (3) and the rear nodal point (3) supplies the controller (4) with an external sum signal formed by adding the control deviation (δx) and the compensation signal (K),
   - wherein the controller (4) determines a control signal (S) for the controlled system (1) with the aid of the external sum signal supplied thereto and outputs the same to the controlled system (1),
   - wherein an external tapping point (7) is arranged between the front and the rear nodal point (2, 3), at which the control deviation (δx) is tapped and supplied to the compensation circuit (5),
   - wherein the compensation circuit (5) determines the compensation signal (K) and supplies it to the rear nodal point (3),
   - wherein the compensation circuit (5) comprises an inner nodal point (8), a frequency filter (9), a front buffer store (10) and a rear buffer store (11),
   - wherein the control deviation (δx) weighted with a first weighting factor (γ) and a feedback signal (R) weighted with a second weighting factor (β) are supplied to the inner nodal point (8),
   - wherein the inner nodal point (8) supplies an inner sum signal formed by adding a weighted control deviation (δx) and a weighted feedback signal (R) to the frequency filter (9),
   - wherein the frequency filter (9) implements a frequency filtering and supplies the filtered signal to the front buffer store (10),
   - wherein the front buffer store (10) implements a first running time delay (T1) and supplies the correspondingly delayed signal to the rear buffer store (11),
   - wherein the rear buffer store (11) implements a second running time delay (T2) and outputs the correspondingly delayed signal as a feedback signal (R),
   - wherein an inner tapping point (14) is arranged between the front buffer store (10) and the rear buffer store (11), at which the compensation signal (K) is tapped and supplied to the rear nodal point (3), and
   - wherein the frequency filter (9) and the two buffer stores (10, 11) are designed such that the sum of the delay times (TF, T1, T2) of the frequency filter (9) and both buffer stores (10, 11) is an integer multiple of the cycle duration (T) of the malfunction (z) and the sum of the delay times (TF, T1) of the frequency filter (9) and the front buffer store (10) is an integer multiple of the cycle duration (T) of the malfunction (z) minus the running time (TL), which elapses until a signal supplied to the front nodal point (2) effects a change in the actual value (x).

2. Control facility according to claim 1,
   **characterised in**
   **that** the frequency filter (9) is embodied as a non-recursive digital filter.

3. Control facility according to claim 2,
   **characterised in**
   **that** the frequency filter (9) is embodied as a low pass filter.

4. Control facility according to claim 2 or 3,
   **characterised in**
   **that** a filter order of the frequency filter (9) can be adjusted.

5. Control facility according to claim 1,
   **characterised in**
   **that** the frequency filter (9) has a number of orthogonal correlation filters (36), by means of which an individual frequency component is filtered out in each case.

6.  Control facility according to one of the above claims,
    **characterised in**
    **that** the first weighting factor ($\gamma$) and the second weighting factor ($\beta$) can be adjusted.

7.  Control facility according to one of the above claims,
    **characterised in**
    **that** the output (16) of the frequency filter (9) can be separated from the inner tapping point (14).

8.  Control facility according to claim 7,
    **characterised in**
    **that** the first weighting factor ($\gamma$), the second weighting factor ($\beta$) and the frequency filter (9) are preferably adjusted such that with an output (16) of the frequency filter (9) which is separated from the inner tapping point (14), an amplification from the inner tapping point (14) to the output (16) of the frequency filter (9) irrespective of a frequency of a signal (u) present at the inner tapping point (14) is less than or at most equal to 1.

9.  Control facility according to claim 8,
    **characterised in**
    **that** the amplification can be output via an output facility (17) to a user (15) of the control facility as a function of the frequency.

10. Control facility according to one of the above claims **characterised in**
    **that** at least one further controller (18, 19) is subordinate to the controller (4) and that a pre-control signal (V1, V2) derived from the signals stored in the front buffer store (10) is supplied to the subordinate controller (18, 19).

11. Control facility according to one of the above claims,
    **characterised in**
    **that** the cycle duration (T) varies over time (t) and that at least the delay time (T1) of the front buffer store (10) is traced dynamically according to the cycle duration (T).

12. Control facility according to claim 11,
    **characterised in**
    **that** the controlled system (1) is embodied as a rotary axis,
    **that** the controller (4) is embodied as a position controller, that an associated position value (p) is assigned to the signals stored in the front and in the rear buffer store (10, 11) and that when varying the cycle duration (T), the compensation circuit (5) determines the compensation signal (K) by taking the position values (p) assigned to the signals stored in the front and rear buffer store (10, 11) into account.

13. Control facility according to one of the above claims
    **characterised in**
    **that** it is embodied as a software-programmable control facility and is programmed with a software module (39), so that on account of the programming with the software module (39) it is embodied according to one of the above claims.

14. Software-programmable control facility for controlling a controlled system (1),

    - wherein the control facility comprises a microprocessor (38) which is programmed with a software module (39) such that
    - the control facility has a front nodal point (2), a rear nodal point (3), a controller (4) and a compensation circuit (5),
    - an actual value (x) acquired by means of a measuring facility (6) on the output side of the controlled system (1) and a corresponding target value (x*) are supplied to the front nodal point (2) and the front nodal point (2) determines a control deviation ($\delta$x) by differentiating between the target value (x*) and the actual value (x),
    - the acquired actual value (x) is subjected to a malfunction (z) comprising a cycle duration (T),
    **characterised in that**
    - the control deviation ($\delta$x) and a compensation signal (K) are supplied to the rear nodal point (3) and the rear nodal point (3) supplies the controller (4) with an external sum signal formed by adding the control deviation ($\delta$x) and the compensation signal (K),
    - the controller (4) determines a control signal (S) for the controlled system (1) with the aid of the external sum signal supplied thereto and outputs the same to the controlled system (1),
    - an external tapping point (7) is arranged between the front and the rear nodal point (2, 3), at which the control deviation (δx) is tapped and supplied to the compensation circuit (5),
- the compensation circuit (5) determines the compensation signal (K) and supplies it to the rear nodal point (3),
- the compensation circuit (5) comprises an inner nodal point (8), a frequency filter (9), a front buffer store (10) and a rear buffer store (11),
- the control deviation (δx) weighted with a first weighting factor (γ) and a feedback signal (R) weighted with a second weighting factor (β) are supplied to the inner nodal point (8),
- the inner nodal point (8) supplies an inner sum signal formed by adding a weighted control deviation (δx) and a weighted feedback signal (R) to the frequency filter (9),
- the frequency filter (9) implements a frequency filtering and supplies the filtered signal to the front buffer store (10),
- the front buffer store (10) implements a first running time delay (T1) and supplies the correspondingly delayed signal to the rear buffer store (11),
- the rear buffer store (11) implements a second running time delay (T2) and outputs the correspondingly delayed signal as a feedback signal (R),
- an inner tapping point (14) is arranged between the front buffer store (10) and the rear buffer store (11), at which the compensation signal (K) is tapped and supplied to the rear nodal point (3), and
- the frequency filter (9) and the two buffer stores (10, 11) are designed such that the sum of the delay times (TF, T1, T2) of the frequency filter (9) and both buffer stores (10, 11) is an integer multiple of the cycle duration (T) of the malfunction (z) and the sum of the delay times (TF, T1) of the frequency filter (9) and the front buffer store (10) is an integer multiple of the cycle duration (T) of the malfunction (z) minus the running time (TL), which elapses until a signal supplied to the front nodal point (2) effects a change in the actual value (x).

15. Software-programmable control facility according to claim 14,
**characterised in**
**that** the software module (39) is stored on a data carrier (41) in machine-readable form.

**Revendications**

1. Dispositif de réglage pour régler une section (1) de réglage,

- dans lequel le dispositif de réglage a un point (2) nodal avant, un point (3) nodal arrière, un régleur (4) et un circuit (5) de compensation,
- dans lequel il est envoyé, au point (2) nodal avant, une valeur (x) réelle détectée du côté de la sortie de la section (1) de réglage au moyen d'un dispositif (6) de mesure et une valeur (x*) de consigne correspondant et le point (2) nodal avant détermine, par formation de la différence entre la valeur (x*) de consigne et la valeur (x) réelle, une différence (δx) de réglage,
- dans lequel la valeur (x) réelle détectée a une perturbation (z) ayant une durée (T) de période,
**caractérisé en ce que**
- il est envoyé, au point (3) nodal arrière, la différence (δx) de réglage et un signal (K) de compensation et le point (3) nodal arrière envoie, au régleur (4), un signal somme extérieur formé par addition de la différence (δx) de réglage et du signal (K) de compensation,
- dans lequel le régleur (4) détermine, à l'aide du signal somme extérieur qui lui est envoyé, un signal (S) de réglage de la section (1) de réglage et l'envoie à la section (1) de réglage,
- dans lequel, entre le point (2) nodal avant et le point (3) nodal arrière, est prévu un point (7) de prélèvement extérieur, où la différence (δx) de réglage est prélevée et envoyée au circuit (5) de compensation,
- dans lequel le circuit (4) de compensation détermine le signal (K) de compensation et l'envoie au point (3) nodal arrière,
- dans lequel le circuit (5) de compensation a un point (8) nodal intérieur, un filtre (9) de fréquence, une mémoire (10) tampon avant et une mémoire (11) tampon arrière,
- dans lequel il est envoyé, au point (8) nodal intérieur, la différence (δx) de réglage pondérée par un premier facteur (γ) de pondération et un signal (R) de réaction pondéré par un deuxième facteur (β) de pondération,
- dans lequel le point (8) nodal intérieur envoie, au filtre (9) de fréquence, un signal somme intérieur formé par l'addition de la différence (δx) de réglage pondérée et du signal (R) de réaction pondéré,
- dans lequel le filtre (9) de fréquence effectue un filtrage de fréquence et envoie le signal filtré à la mémoire (10) tampon avant,
- dans lequel la mémoire (10) tampon avant effectue un premier retard (T1) de temps de propagation et envoie le signal retardé de manière correspondante à la mémoire (11) tampon arrière,

- dans lequel la mémoire (11) tampon arrière effectue un deuxième retard (T2) de temps de propagation et émet le signal retardé de manière correspondante comme signal (R) de réaction,
- dans lequel il y a, entre la mémoire (10) avant et la mémoire (11) arrière, un point (14) de prélèvement intérieur, où le signal (K) de compensation est prélevé et envoyé au point (3) nodal arrière et
- dans lequel le filtre (9) de fréquence et les deux mémoires (10, 11) tampon sont conçus de manière à ce que la somme des temps (TF, T1, T2) de retard du filtre (9) de fréquence et des deux mémoires (10, 11) tampon représente un multiple en nombre entier de la durée (T) de la période de la perturbation (z) et de manière à ce que la somme des temps (TF, T1) de retard du filtre (9) de fréquence et de la mémoire (10) tampon avant représente un multiple en nombre entier de la durée (T) de la période de la perturbation (z), déduction faite du temps (TL) de propagation, qui s'écoule jusqu'à ce qu'un signal envoyé au point (2) nodal avant provoque une variation de la valeur (x) réelle.

2. Dispositif de réglage suivant la revendication 1,
   **caractérisé**
   **en ce que** le filtre (9) de fréquence est constitué sous la forme d'un filtre numérique non-récursif.

3. Dispositif de réglage suivant la revendication 2,
   **caractérisé**
   **en ce que** le filtre (9) de fréquence est constitué sous la forme d'un filtre passe-bas.

4. Dispositif de réglage suivant la revendication 2 ou 3,
   **caractérisé**
   **en ce qu'**un ordre de filtrage du filtre (9) de fréquence est réglable.

5. Dispositif de réglage suivant la revendication 1,
   **caractérisé**
   **en ce que** le filtre (9) de fréquence a un certain nombre de filtres (36) de corrélation orthogonale, au moyen desquels respectivement une composante individuelle de fréquence est filtrée.

6. Dispositif de réglage suivant l'une des revendications précédentes,
   **caractérisé**
   **en ce que** le premier facteur ($\gamma$) de pondération et le deuxième facteur ($\beta$) de pondération sont réglables.

7. Dispositif de réglage suivant l'une des revendications précédentes,
   **caractérisé**
   **en ce que** la sortie (16) du filtre (9) de fréquence peut être séparée du point (14) de prélèvement intérieur.

8. Dispositif de réglage suivant la revendication 7,
   **caractérisé**
   **en ce que** le premier facteur ($\gamma$) de pondération, le deuxième facteur ($\beta$) de pondération et le filtre (9) de fréquence sont réglés de manière à ce que, lorsque la sortie (16) du filtre (9) de fréquence est séparée du point (14) de prélèvement intérieur, une amplification du point (14) de prélèvement intérieur à la sortie (16) du filtre (9) de fréquence soit, indépendamment d'une fréquence d'un signal (u) s'appliquant au point (14) de prélèvement intérieur, inférieure ou au maximum égale à 1.

9. Dispositif de réglage suivant la revendication 8,
   **caractérisé**
   **en ce que** l'amplification peut être envoyée, en fonction de la fréquence, par un dispositif (17) d'émission à un utilisateur (15) du dispositif de réglage.

10. Dispositif de réglage suivant l'une des revendications précédentes,
    **caractérisé**
    **en ce qu'**au moins un autre régleur (18, 19) est sous-jacent au régleur (4) et en ce que, au régleur (18, 19) sous-jacent, est envoyé un signal (V1, V2) pilote déduit de signaux mis en mémoire dans la mémoire (10) tampon avant.

11. Dispositif de réglage suivant l'une des revendications précédentes,
    **caractérisé**
    **en ce que** la durée (T) de la période varie au cours du temps (t) et en ce qu'au moins le temps (T1) de retard de la mémoire (10) tampon avant est adapté dynamiquement, conformément à la durée (T) de la période.

**12.** Dispositif de réglage suivant la revendication 11,
**caractérisé**
**en ce que** la section (1) de réglage est constituée sous la forme d'un axe circulaire, en ce que le régleur (4) est constitué sous la forme d'un régleur de position, en ce que, aux signaux mis en mémoire dans la mémoire (10) tampon avant et dans la mémoire (11) tampon arrière, est affectée respectivement une valeur (p) de position associée et en ce que, lorsque la durée (T) de la période varie, le circuit (5) de compensation détermine le signal (K) de compensation, en tenant compte des valeurs (p) de position affectées aux signaux mis en mémoire dans la mémoire (10) tampon avant et dans la mémoire (11) tampon arrière.

**13.** Dispositif de réglage suivant l'une des revendications précédentes,
**caractérisé**
**en ce qu'**il est constitué sous la forme d'un dispositif de réglage programmable par logiciel et est programmé par un module (39) logiciel, de manière à être constitué suivant l'une des revendications précédentes sur la base de la programmation par le module (39) logiciel.

**14.** Dispositif de réglage programmable par logiciel pour régler une section (1) de réglage,

- dans lequel le dispositif de réglage comprend un microprocesseur (38), qui est programmé par un module (39) logiciel, de manière
- à ce que le dispositif de réglage ait un point (2) nodal avant, un point (3) nodal arrière, un régleur (4) et un circuit (5) de compensation,
- à ce qu'il soit envoyé, au point (2) nodal avant, une valeur (x) réelle détectée du côté de la sortie de la section (1) de réglage au moyen d'un dispositif (6) de mesure et une valeur (x*) de consigne correspondant et le point (2) nodal avant détermine, par formation de la différence entre la valeur (x*) de consigne et la valeur (x) réelle, une différence (δx) de réglage,
- à ce que la valeur (x) réelle détectée ait une perturbation (z) ayant une durée (T) de période,
**caractérisé**
- **en ce qu'**il est envoyé, au point (3) nodal arrière, la différence (δx) de réglage et un signal (K) de compensation et le point (3) nodal arrière envoie, au régleur (4), un signal somme extérieur formé par addition de la différence (δx) de réglage et du signal (K) de compensation,
- **en ce que** le régleur (4) détermine, à l'aide du signal somme extérieur qui lui est envoyé, un signal (S) de réglage de la section (1) de réglage et l'envoie à la section (1) de réglage,
- **en ce que**, entre le point (2) nodal avant et le point (3) nodal arrière, est prévu un point (7) de prélèvement extérieur, où la différence (δx) de réglage est prélevée et envoyée au circuit (5) de compensation,
- **en ce que** le circuit (5) de compensation détermine le signal (K) de compensation et l'envoie au point (3) nodal arrière,
- **en ce que** le circuit (5) de compensation a un point (8) nodal intérieur, un filtre (9) de fréquence, une mémoire (10) tampon avant et une mémoire (11) tampon arrière,
- **en ce qu'**il est envoyé, au point (8) nodal intérieur, la différence (δx) de réglage pondérée par un premier facteur (γ) de pondération et un signal (R) de réaction pondéré par un deuxième facteur (β) de pondération,
- **en ce que** le point (8) nodal intérieur envoie, au filtre (9) de fréquence, un signal somme intérieur formé par l'addition de la différence (δx) de réglage pondérée et du signal (R) de réaction pondéré,
- **en ce que** le filtre (9) de fréquence effectue un filtrage de fréquence et envoie le signal filtré à la mémoire (10) tampon avant,
- **en ce que** la mémoire (10) tampon avant effectue un premier retard (T1) de temps de propagation et envoie le signal retardé de manière correspondante à la mémoire (11) tampon arrière,
- **en ce que** la mémoire (11) tampon arrière effectue un deuxième retard (T2) du temps de propagation et émet le signal retardé de manière correspondante comme signal (R) de réaction,
- **en ce qu'**il y a, entre la mémoire (10) avant et la mémoire (11) arrière, un point (14) de prélèvement intérieur, où le signal (K) de compensation est prélevé et envoyé au point (3) nodal arrière et
- **en ce que** le filtre (9) de fréquence et les deux mémoires (10, 11) tampon sont conçus de manière à ce que la somme des temps (TF, T1, T2) de retard du filtre (9) de fréquence et des deux mémoires (10, 11) tampon représente un multiple en nombre entier de la durée (T) de la période de la perturbation (z) et de manière à ce que la somme des temps (TF, T1) de retard du filtre (9) de fréquence et de la mémoire (10) tampon avant représente un multiple en nombre entier de la durée (T) de la période de la perturbation (z), déduction faite du temps (TL) de propagation, qui s'écoule jusqu'à ce qu'un signal envoyé au point (2) nodal avant provoque une variation de la valeur (x) réelle.

15. Dispositif de réglage programmable par logiciel suivant la revendication 14, **caractérisé en ce que** le module (39) logiciel est mis en mémoire sur un support (41) de données sous une forme déchiffrable par ordinateur.

FIG 1

FIG 2

FIG 3

FIG 4

FIG 5

# FIG 6

# FIG 7

FIG 8

FIG 9

FIG 10

FIG 11

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 2116912 A